(19) Europäisches Patentamt / European Patent Office / Office européen des brevets

(11) **EP 3 238 240 B1**

(12) **FASCICULE DE BREVET EUROPEEN**

(45) Date de publication et mention
de la délivrance du brevet:
**10.06.2020 Bulletin 2020/24**

(21) Numéro de dépôt: **15817370.8**

(22) Date de dépôt: **22.12.2015**

(51) Int Cl.:
*H01L 21/66* (2006.01)        *H01L 25/075* (2006.01)
*H01L 27/15* (2006.01)        *H01L 33/08* (2010.01)
*H01L 33/62* (2010.01)

(86) Numéro de dépôt international:
**PCT/EP2015/081063**

(87) Numéro de publication internationale:
**WO 2016/102610 (30.06.2016 Gazette 2016/26)**

(54) **SOURCE DE LUMIERE ELECTROLUMINESCENTE A PARAMETRE DE LUMINANCE AJUSTE OU AJUSTABLE EN LUMINANCE ET PROCEDE D'AJUSTEMENT D'UN PARAMETRE DE LUMINANCE DE LA SOURCE DE LUMIERE ELECTROLUMINESCENTE**

ELEKTROLUMINESZENZ-LEUCHTQUELLE MIT EINER EINSTELLBAREN ODER EINGESTELLTEN LEUCHTDICHTE UND LEUCHTDICHTE EINSTELLUNGSPROZESS DER ELEKTROLUMINESZENZ-LEUCHTQUELLE

ELECTROLUMINESCENT LIGHT SOURCE WITH AN ADJUSTABLE OR ADJUSTED LUMINANCE PARAMETER AND LUMINANCE PARAMETER ADJUSTMENT PROCESS OF THE ELECTROLUMINESCENT LIGHT SOURCE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.12.2014 FR 1463179**

(43) Date de publication de la demande:
**01.11.2017 Bulletin 2017/44**

(73) Titulaire: **Aledia**
**38040 Grenoble (FR)**

(72) Inventeur: **HUGON, Xavier**
**38470 Teche/Vinay (FR)**

(74) Mandataire: **Esselin, Sophie et al**
**Marks & Clerk France**
**Conseils en Propriété Industrielle**
**Immeuble Visium**
**22 avenue Aristide Briand**
**94117 Arcueil Cedex (FR)**

(56) Documents cités:
| | |
|---|---|
| EP-A2- 2 778 511 | WO-A1-2007/034367 |
| WO-A1-2010/014032 | DE-A1-102012 102 301 |
| DE-A1-102013 104 273 | US-A1- 2012 301 982 |

**Description**

DOMAINE DE L'INVENTION

Le domaine de l'invention est celui des sources de lumière électroluminescentes de type diodes électroluminescentes, couramment désignées par l'acronyme LED (« Light Emitting Diode »).

ETAT DE LA TECHNIQUE

Actuellement, les rendements de fabrication des LEDs sont assez fortement impactés par les variations de caractéristiques relatives de l'évolution de leur luminance avec la tension appliquée L(V) ou la variation de leur luminance avec le courant de commande L(I) ou bien encore de la luminance maximale pouvant être obtenue Lmax.

De manière générale, les fabricants de luminaires ou d'ampoules assemblent des dizaines voire des centaines de LEDs unitaires dans un système. Ces LEDS sont montées soit en série (même courant pour toutes) soit en parallèle (même tension pour toutes) soit en mixant les deux. Les variations de LED à LED sont très pénalisantes pour l'uniformité d'aspect, voire pour la fonctionnalité du système, ce qui impose aux intégrateurs de spécifier une gamme acceptable de couples en termes de tension de commande et de luminance (V, L) ou de courant de commande et de luminance (I, L). Les fabricants de LED doivent donc trier les composants sur ces paramètres en sortie de production et éliminer tous les composants qui ne sont pas dans la gamme voulue. Plus la dispersion des performances des composants sera grande, plus les chutes de rendement seront importantes.

De manière générale, pour réaliser un dispositif LED, on peut réaliser à la surface d'un même substrat des éléments unitaires électroluminescents 2D ou 3D au niveau de la surface d'émission, on alimente électriquement chacun de ces éléments unitaires montés en série et/ou en parallèle de manière à générer de la lumière, via un circuit de commande. On peut néanmoins toujours avoir des variations de performance d'un élément unitaire à l'autre, conduisant à des performances globales fluctuantes alors que les intégrateurs ont à respecter des contraintes de performances dans une plage définie.

De manière générique, il est défini qu'une puce LED correspond à un élément monolithique dont la matière a été organisée pour constituer une structure électroluminescente, disposant d'au moins deux accès électriques pour son alimentation. Un composant LED est une puce (élément monolithique) dans un boîtier assurant tout ou partie des interfaces électriques, thermiques, mécaniques et optiques avec le système utilisateur. Il est à noter que le boîtier peut se résumer à un revêtement particulier de la puce lui permettant d'être directement utilisée dans le système (technique du « Chip On Board » par exemple.)

Plus précisément, et de manière connue des LEDs unitaires peuvent présenter aussi bien des micro-structures planaires dites 2D que des micro-structures ou nano-structures 3D comprenant des éléments tridimentionnels filaires, côniques, tronconiques ou, pyramidaux. Dans la suite de la présente description, on désignera par « fil » tout élément tridimensionnel de l'un des types sus-cités. Les dimensions latérales (diamètre) des fils peuvent par exemple être de l'ordre de quelques centaines de nanomètres et leur dimension verticale peut aller jusqu'à une dizaine de micromètres, avec un rapport hauteur / diamètre allant de 1 à 30 et typiquement autour de 10.

Au cours de ces dernières années, il a été réalisé par exemple, des diodes électroluminescentes visibles à base de fils InGaN/GaN verticaux contenant une jonction p-n et connectés collectivement en parallèle.

Grâce à leurs propriétés intrinsèques potentielles (bonne qualité cristalline, relaxation des contraintes aux surfaces libres verticales, bonne efficacité d'extraction de la lumière par effet de guide d'onde...), les fils sont également considérés comme des candidats très intéressants pour la réalisation de dispositifs électroluminescents.

Deux approches LEDs à base de fils, utilisant des techniques de croissance différentes, ont déjà été proposées.

La première filière consiste à épitaxier des fils GaN contenant des puits quantiques InGaN en configuration axiale par Epitaxie par Jet Moléculaire (MBE). Les dispositifs fabriqués à partir de ces fils ont donné des résultats intéressants dans le domaine spectral vert. Les puces processées de 1 $mm^2$ peuvent émettre autour de 10 $\mu$W à 550 nm pour un courant continu de fonctionnement de 100 mA.

Avec la technique de croissance par jets moléculaires (MBE), certaines inhomogénéités apparaissent en raison de mécanismes de nucléation aléatoire, mais typiquement il a été obtenu une puissance optique sur un fil unique émettant à 550nm de 50nW, soit 5 $mW/mm^2$ avec une centaine de milliers de fils émetteurs/$mm^2$.

Plus récemment, la technique de croissance MOCVD (dépôt chimique en phase vapeur à base d'organométalliques) a permis la réalisation de fils In-GaN/GaN contenant une structure LED radiale (configuration Cœur/Coquille).

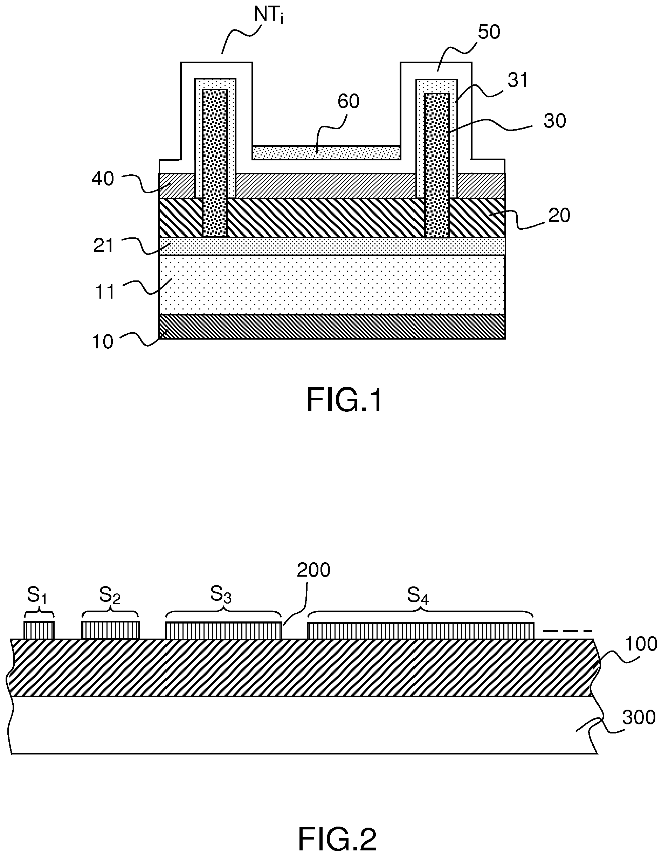

La figure 1 illustre ce type de configuration dans laquelle, des fils $NT_i$ sont réalisés à la surface d'un substrat 11 recouvert d'une couche de nucléation 21, une couche de contact inférieur 10 étant également prévue. L'épitaxie localisée est assurée au travers d'un masque 20. La structure des fils est de type cœur/coquille. Le cœur 30 peut comprendre un matériau GaN dopé n, typiquement avec un taux de dopage de $10^{19}$ $cm^{-3}$, une structure à puits quantique avec une alternance de couches, pouvant respectivement être en GaN non dopée et InGaN, et enfin une coquille 31 pouvant être constituée d'une couche GaN dopée p avec typiquement un taux

de dopage de $10^{19}$ cm$^{-3}$.

Une couche diélectrique 40 assure l'isolation entre les contacts inférieur et supérieur.

Le contact supérieur est assuré via une couche supérieure 50, conductrice et transparente à la longueur d'onde d'émission de la structure photoconductrice. Une couche de contact métallique 60 étant également prévue.

Dans cette approche, la structure LED étant en configuration Cœur/Coquille, la surface de la zone active est plus importante que dans l'approche LEDs fils 2D.

Cette propriété apporte deux avantages : l'augmentation de la surface émissive et la diminution des densités de courant dans la zone active. Des structures complètes de LEDs fils MOCVD ont été réalisées sur substrat silicium et l'électroluminescence dans le domaine spectral bleu (450nm) a été obtenue sur un ensemble de fils intégrés après process technologique.

Grâce aux technologies de croissance de fils, la surface d'une puce peut comprendre des centaines de milliers de fils sur une surface pouvant typiquement être de 1 mm$^2$,

Il est connu du Document EP 2 778 511, une source comprenant une matrice d'éléments lumineux incluant des cellules individuellement contrôlables.

Le Document DE 10 2012 102301 décrit une LED monolithique segmentée présentant des segments de dimensions différentes adressables individuellement.

Le Document WO 2010/014032 décrit une LED nanostructurée comportant des nanofils.

D1 se rapporte à une source de lumière comprenant une puce LED dont la zone active est segmentée en segments contrôlables individuellement.

DESCRIPTION DE L'INVENTION

Dans ce contexte et pour répondre notamment aux contraintes de reproductibilité de source de lumière électroluminescente, la présente invention décrit une source de lumière électroluminescente comprenant plusieurs éléments électroluminescents discrets pouvant être de très petite taille, ayant typiquement des dimensions pouvant descendre jusqu'à quelques centaines de nanomètres, ainsi que les moyens permettant d'en ajuster des paramètres de luminance et par conséquent, la reproductibilité, la luminance résultant de la somme des luminances élémentaires d'au moins un ensemble d'éléments électroluminescents discrets organisés en segments de dimensions différentes, lesdits segments pouvant être commandés de manière indépendante et sélective et permettant ainsi notamment aux constructeurs de respecter des consignes imposées en termes de couples de tension de commande et de luminance (V, L) ou de courant de commande et de luminance (I, L).

L'invention est définie par les revendications. Ainsi, les sources de lumière "selon l'invention" possèdent les caractéristiques définies par la revendication 1.

Plus précisément, la présente invention a pour objet une source de lumière électroluminescente à paramètre de luminance ajusté ou ajustable ((I, L), (V,L), ...) selon la revendication 1,

- ladite source comportant un ensemble de N segments ($S_i$) avec N > 2, chaque segment présentant une surface d'émission et comprenant un élément discret électroluminescent ou plusieurs éléments discrets électroluminescents connectés de manière permanente entre eux, avec :

  ◦ soit ladite source comprenant des éléments filaires, coniques, tronconiques ou pyramidaux à la surface d'un substrat et répartis en sous-ensembles correspondant auxdits segments, chaque segment possédant un nombre différent d'éléments filaires, coniques, tronconiques ou pyramidaux connectés de manière permanente entre eux, les éléments discrets électroluminescents étant lesdits éléments filaires, coniques, tronconiques ou pyramidaux ;
  ◦ soit ladite source comprenant une diode électroluminescente (LED) présentant une partie active émissive segmentée de manière à définir lesdits segments, ladite diode électroluminescente (LED) présentant une structure planaire d'empilement de couches à la surface d'un substrat, les segments ayant une surface différente, chaque segment étant un élément discret électroluminescent ;
  ◦ soit ladite source comprenant un assemblage de puces de diodes électroluminescentes (LEDs) discrètes, réparties entre lesdits segments, chaque segment étant constitué d'au moins une puce, les segments comprenant un nombre différent de puces de diodes électroluminescentes (LEDs) connectées de manière permanente entre elles ou des puces de diodes électroluminescentes (LEDs) de tailles différentes, les éléments discrets électroluminescents étant lesdites puces de diodes électroluminescentes (LEDs) discrètes ;

- lesdits segments présentant des surfaces d'émission variant en puissance de 2 ;
- ladite source comprenant des moyens de commande d'au moins une partie desdits segments ($S_i$).

Selon une variante de l'invention, la source de lumière comprend des éléments filaires, coniques, tronconiques ou pyramidaux à la surface d'un substrat et répartis en sous-ensembles appelés segments. Selon cette variante, chaque segment possède un nombre différent d'éléments discrets, ce nombre variant en puissance de 2.

Selon une variante de l'invention, la source de lumière comprend une diode électroluminescente (LED) présentant une partie active émissive segmentée de manière à définir lesdits segments, ladite diode électroluminescente (LED) présentant une structure planaire d'empilement de couches à la surface d'un substrat. Selon cette variante, les segments présentent une surface différente. Les segments ont des surfaces variant en puissance de deux.

Ainsi selon des variantes de l'invention, la source de lumière électroluminescente comprend une série de N ième segments, le nombre d'éléments filaires, coniques, tronconiques ou pyramidaux dans chaque ième segment variant en puissance de 2, avec N > 2.

Selon des variantes de l'invention, la source de lumière électroluminescente comprend une série de N ième segments, la taille des ièmes segments variant en puissance de 2, avec N > 2.

Selon des variantes de l'invention, la source de lumière comprend N ième segments, les puces constituant les N ième segments ont des surfaces variant en puissance de deux et/ou en ce que le nombre de puces constituant un ième segment varie en puissance de 2, avec N > 2.

Selon des variantes de l'invention, la source de lumière comprend au moins une partie desdits segments est constituée de groupes positionnés de manière non-contigüe, lesdits groupes étant connectés de manière permanente entre eux.

Selon une variante de l'invention, la source de lumière comprend un assemblage de puces de diodes électroluminescentes (LEDs) discrètes, réparties en plusieurs segments constitués d'une puce ou de plusieurs puces.

Selon des variantes de l'invention, les éléments discrets sont connectés électriquement par une électrode supérieure commune. Chaque groupe d'éléments discrets d'un même segment peut être relié à au moins un via traversant le substrat et permettant la connexion des groupes dudit segment en face arrière.

Selon des variantes de l'invention, les segments sont connectés par plusieurs niveaux de métal sur la face processée des puces assemblées en mode retourné « flip-chip ».

La technique de retournement de puces (traduction de flip chip) est une des techniques utilisées pour effectuer les connexions électriques. La puce est retournée à l'inverse du câblage par fil (couramment dénommé « wire bonding »).

Selon des variantes de l'invention, les différentes diodes électroluminescentes (LEDs) constituants les segments sont reportées sur un support assurant également la connexion électrique des segments et groupes.

Selon des variantes de l'invention, les moyens de commande comprennent un circuit de commande comportant des moyens pour activer indépendamment un nombre variable de segments et permettant d'ajuster ledit paramètre de luminance de ladite source. Selon une variante de l'invention, le circuit de commande contient des pistes conductrices reliant les segments à un ou plusieurs plots métalliques permettant leur connexion filaire (appelée Wire bonding) lors de la mise en boitier de la dite source. Selon une variante de l'invention le circuit de commande peut être un circuit imprimé comportant des pistes conductrices reliées aux segments et un module électronique de commande, ledit module permettant d'activer au moins une partie desdits segments via les pistes conductrices. Le circuit de commande peut comprendre des moyens de commande binaire. Les pistes conductrices peuvent comporter des moyens de programmation sélective et permanente des connexions préétablies, lesdits moyens pouvant être de type fusibles métalliques. Le procédé employé peut consister en l'élimination des fusibles métalliques par ablation laser.

Pour assurer une commande binaire, le module électronique de commande peut comporter un répertoire de couples de données : routage des pistes de commande/ paramètre global de luminance dudit dispositif.

Selon des variantes de l'invention, les segments sont capables d'émettre à des longueurs d'onde $\lambda_{pk}$ différentes, la combinaison desdits segments générant un paramètre de luminance globale résultant de la somme des paramètres de luminance de chacun des segments émettant à une desdites longueurs d'onde $\lambda_{pk}$.

L'invention a aussi pour objet un procédé de fabrication d'une source de lumière électroluminescente selon la revendication 14.

L'invention a aussi pour objet un procédé d'utilisation d'une source de lumière électroluminescente selon les revendications 17 et 18.

L'invention sera mieux comprise et d'autres avantages apparaîtront à la lecture de la description qui va suivre donnée à titre non limitatif et grâce aux figures annexées parmi lesquelles :

- la figure 1 illustre une configuration de LED utilisant des fils à structure radiale selon l'art connu ;
- la figure 2 schématise une source de lumière électroluminescente de l'invention, constituée d'éléments électroluminescents de type nanostructures pouvant être ceux décrits dans la figure 1, et comportant des segments de surface d'émission différentes constitués d'un nombre différents d'éléments électroluminescents ;
- les figures 3a et 3b schématisent la vue de dessus et une coupe d'une source de lumière électroluminescente ne faisant pas partie de l'invention, ayant une structure planaire comportant des segments d'éléments électroluminescents de structure planaire ;
- les figures 3c et 3d schématisent la vue de dessus et une coupe d'une source de lumière électroluminescente ne faisant pas partie de l'invention, comportant des segments comprenant au moins un élément discret électroluminescent de structure planaire connectés en mode « flip-chip » ;
- la figure 4 schématise une source de lumière électroluminescente ne faisant pas partie de l'invention, comportant des segments d'éléments discrets électroluminescents 3D ;

- les figures 5a et 5b schématisent respectivement une vue de dessus et une vue de dessous d'un exemple de source de lumière électroluminescente ne faisant pas partie de l'invention comprenant des segments comportant des groupes non-contigus ;
- les figures 6a et 6b illustrent des exemples de schémas de connexion des segments utilisés dans une source de lumière selon l'invention ;
- la figure 7 représente la distribution statistique en production de la luminance d'une source de lumière LED de surface active S.

DESCRIPTION DETAILLEE DE L'INVENTION

De manière générale, la source de lumière de la présente invention est constituée d'une surface électroluminescente globale S segmentée en plusieurs parties électroluminescentes distinctes appelées segments.

Selon une variante de l'invention, la source de lumière peut-être une diode électroluminescente comprenant un grand nombre de fils ayant crû à la surface d'un substrat, organisés en segments de surfaces émissives différentes. Une telle variante est illustrée en figure 2. La figure 2 représente une source de lumière électroluminescente comprenant à la surface d'un substrat 100 des segments $S_1$, $S_2$, $S_3$, $S_4$, ..., d'éléments électroluminescents 200, de surface émissive de taille différente.

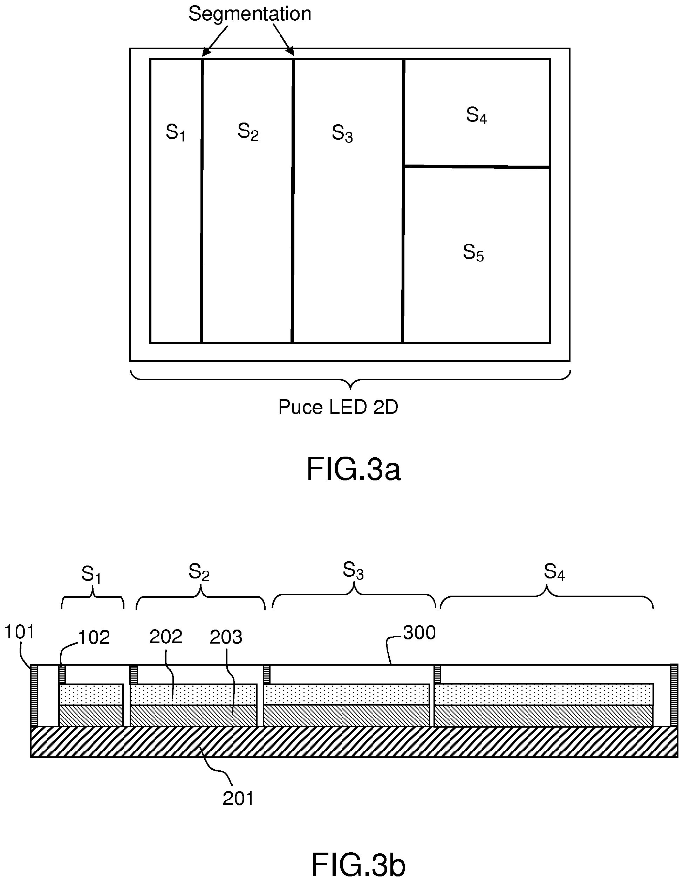

Selon une autre variante de l'invention, la source de lumière de l'invention peut-être une source de lumière 2D segmentée en plusieurs parties, chacune de ces parties correspondant à un segment. Les deux figures 3a et 3b illustrent cette variante de l'invention. La figure 3a représente la vue du dessus d'une LED 2D avec 5 segments $S_1$, $S_2$, $S_3$, $S_4$ et $S_5$. Les traits noirs représentent la segmentation de la partie active de la LED en différents segments. La figure 3b représente une coupe de la même LED avec un substrat commun assurant le contact n, pour tous les segments et une segmentation du contact p et de la partie émissive active. Les petits plots représentant les prises de contact électrique. Plus précisément, à la surface d'un substrat commun 201 assurant un contact n, sont réalisés des segments comprenant une zone active émissive 203, un contact de type p 202, les reprises respectivement des contacts n 101 et contacts p 102 sont reliées à des moyens 300 pouvant comprendre un circuit de commande.

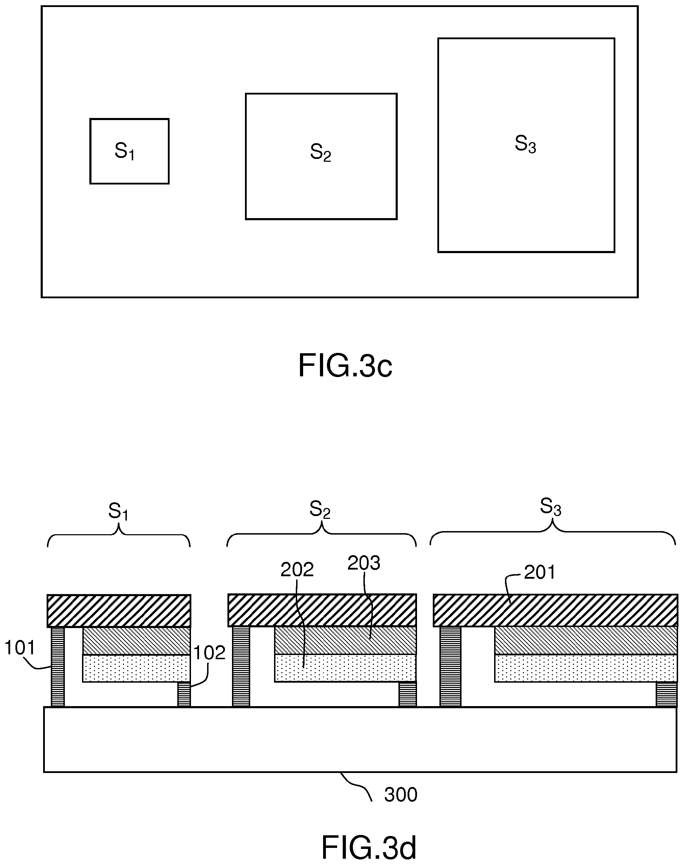

Selon une autre variante de l'invention, la source de lumière de l'invention peut comprendre un assemblage de LEDs discrètes, en technologie 2D ou 3D, de taille ou de paramètres différents, chaque segment étant constitué d'une ou de plusieurs de ces LEDs disposées sur un support commun ou plusieurs supports disposés de manière commune dans un même boitier. L'assemblage est réalisé par une méthode de type « flip-chip » avec report des contacts sur un support commun assurant un contact n, comme illustré en figures 3c et 3d qui mettent en évidence, trois segments réalisés $S_1$, $S_2$ et $S_3$ Les éléments discrets sont réalisés à la surface de substrats élémentaires 201 assurant le contact n, présentant une partie émissive 203 et un contact p 202. Les reprises de contact 101 (du contact n) et 102 (du contact p) sont reliées à des moyens comprenant un circuit de commande 300.

Selon une variante de l'invention, chaque segment de la source de lumière électroluminescente comprend un ensemble de $n_i$ éléments discrets électroluminescents, le nombre $n_i$ variant d'un segment à l'autre, au moins pour une partie desdits segments. Ainsi la puissance lumineuse émise par chaque segment varie en fonction des segments et du nombre $n_i$ d'éléments qu'ils contiennent.

Plus le nombre $n_i$ d'élément est élevé et plus la luminosité émise par le segment est importante.

Selon l'invention, les surfaces d'émission desdits segments varient selon un ordre croissant, et selon une variante de l'invention, lesdits segments sont répartis aléatoirement au niveau d'un substrat ou d'un support.

Selon l'invention, les surfaces d'émission desdits segments varient en puissance de 2.

Selon une variante de l'invention :

- les éléments discrets présentent une structure de type p-n ou pi-n, avec un élément de contact n (respectivement p) au niveau du substrat et une couche de contact p (respectivement n) supérieure, lesdits segments étant situés sur une première face d'un substrat ;
- ledit substrat comprend en face arrière une première série de plots de reprise de contact n (respectivement p) et une seconde série de plots de reprise de contact p (respectivement n) ;
- ledit substrat comprend des via traversant et conducteurs ;
- ladite couche de contact p (respectivement n) supérieure est reliée auxdits vias traversants et conducteurs, et ainsi à la première série de plots de reprise de contact p (respectivement n) ;
- l'élément de contact n (respectivement p) étant relié via le substrat à la seconde série de plots de reprise de contact n (respectivement p).

Typiquement, l'élément de contact n (respectivement p) peut être le cœur d'une structure cœur/coquille, dans un fil.

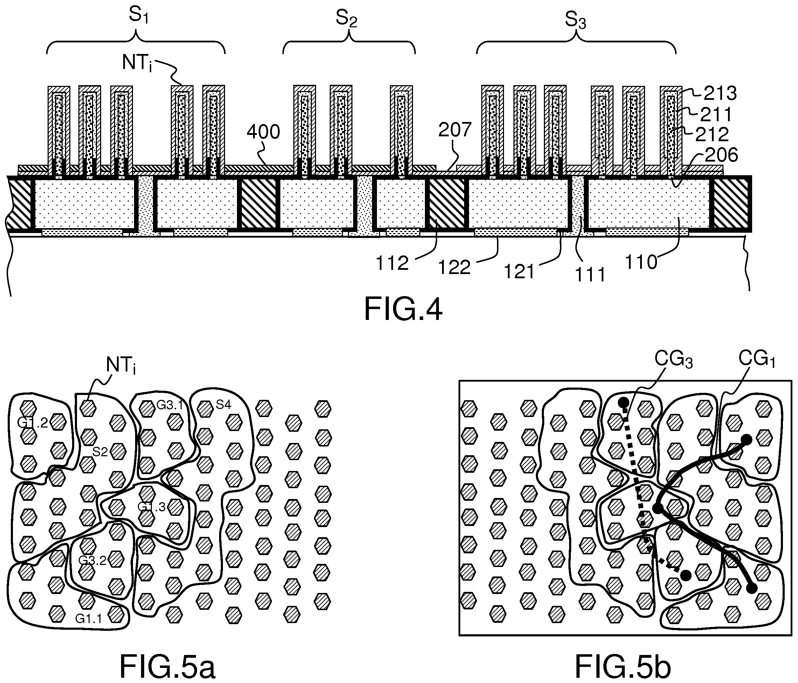

La figure 4 est une illustration de cette variante ne faisant pas partie de l'invention dans laquelle sont représentés 3 segments $S_1$, $S_2$, $S_3$ :

- le segment $S_1$ comporte 5 fils, NTi ;
- le segment $S_2$ comporte 3 fils, NTi ;
- le segment $S_3$ comporte 6 fils, NTi ;

Chaque segment comprend des éléments discrets reliés entre eux par une électrode commune et un via conducteur traversant.

Plus précisément, des fils pouvant être de type cœur/coquille sont réalisés à la surface d'un substrat 110, à partir de plots de nucléation 206. La structure cœur/coquille comprend un cœur 212 pouvant être dopé n, une structure active 211 pouvant être recouverte d'une couche externe dopée p. Une couche d'électrode 213 supérieure permet de connecter en parallèle entre eux différents fils contigus.

L'émission étant réalisée en face avant, le dispositif peut avantageusement comprendre une couche miroir 400, permettant de rediriger le maximum de lumière en face avant.

Le substrat 110 comporte des vias traversants et conducteurs 111. Une couche d'isolation 207 permet d'isoler les contacts de type p, schématisés par les plots 121, des contacts de type n étant assurés par des plots 122. Le substrat 110, comporte également des portions isolantes 112, permettant d'isoler les segments entre eux.

Un circuit de commande 310 permet de connecter indépendamment des segments les uns des autres.

Ainsi les reprises de connexions peuvent être réalisées en face arrière, et ce par une méthode pouvant être de type « TSV » correspondant à l'acronyme anglosaxon : « Through Silicon Vias ».

De manière générale, les TSV, permettent de réaliser des interconnexions métalliques traversant les couches de silicium (plaque ou puce). Suivant les applications, les diamètres des TSV varient entre 1 et 100$\mu$m et ont des facteurs de forme, correspondant au rapport de leur hauteur sur leur largeur, entre 1 et 30.

Afin d'obtenir des facteurs de formes raisonnables et réalisables, il est généralement nécessaire d'amincir les plaques (ou puces) de silicium à des épaisseurs inférieures à 100$\mu$m (l'épaisseur initiale d'une plaque de silicium étant de l'ordre de 725$\mu$m).

Selon une variante de l'invention, la source de lumière électroluminescente comporte :

- des segments qui comprennent des groupes constitués de fils connectés électriquement entre eux ;
- lesdits groupes d'un même segment n'étant pas répartis de manière contigüe et pouvant être répartis de manière aléatoire.

Selon une variante de l'invention, les éléments électroluminescents discrets d'un même groupe sont connectés entre eux par une électrode supérieure commune.

Selon une variante de l'invention, les groupes d'un même segment sont reliés électriquement entre eux en face dite arrière du substrat opposée à ladite première face supportant lesdits groupes.

Les figures 5a et 5b illustrent un exemple de source de lumière électroluminescente comprenant des segments dont certains comportent eux-mêmes des sous-ensembles d'éléments discrets 3D, appelés groupes.

Selon cet exemple, la source de lumière comprend comme le schématise la figure 5a en vue de dessus :

- un premier segment comportant trois groupes $G_{1,1}$ ; $G_{1,2}$ ; $G_{1,3}$ constitués d'éléments discrets contigus ;
- un second segment $S_2$ constitué d'éléments discrets contigus ;
- un troisième segment comprenant deux groupes $G_{3,1}$ et $G_{3,2}$ constitués d'éléments discrets contigus ;
- un quatrième segment $S_4$ constitué d'éléments discrets contigus.

Les différents niveaux de gris représentent les connexions électriques communes dans un même segment en face dite avant, soit au niveau de la surface comportant les éléments discrets NTi.

La figure 5b schématise une vue en face arrière du substrat supportant les éléments NTi et met en évidence les connexions en face arrière pour un même segment comportant plusieurs groupes. Ainsi la connexion $CG_1$ connecte électriquement entre eux, les trois groupes $G_{1,1}$ ; $G_{1,2}$ ; $G_{1,3}$ et la connexion $CG_3$ connecte électriquement entre eux, les deux groupes $G_{3,1}$ ; $G_{3,2}$.

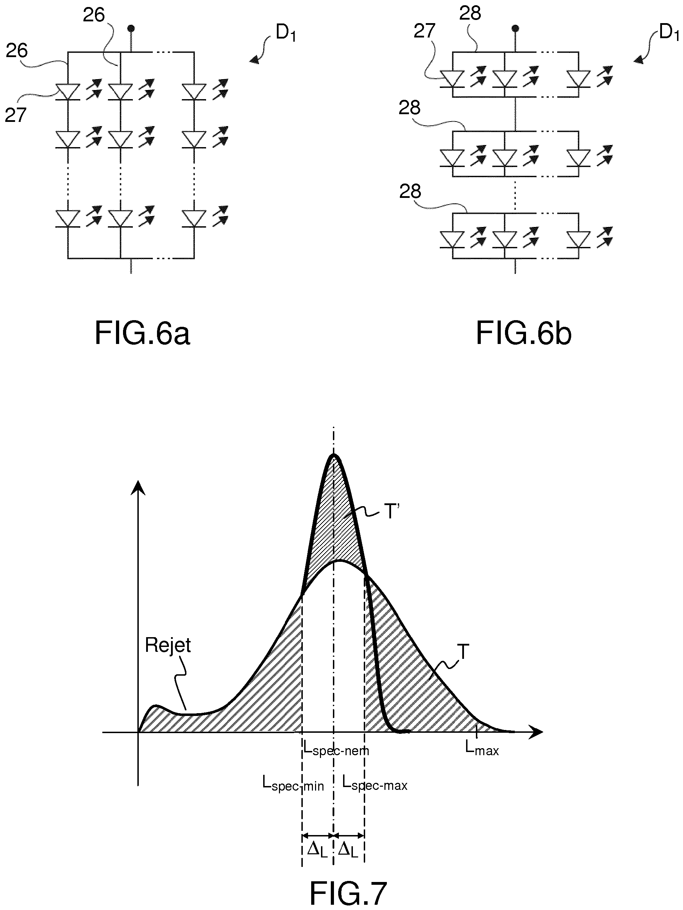

D'un point de vue électrique chaque segment est assimilable à une LED individuelle. Les segments sont ainsi autant de LEDs individuelles connectées ou connectables de manière générale en parallèle. Cependant la source de lumière de l'invention peut présenter un schéma de connexion plus complexe de type série/parallèle. Cela permet notamment d'obtenir des modules lumineux ayant des tensions de fonctionnement plus élevées. Les figures 6a et 6b illustrent à titre d'exemple deux schémas de connexions possibles pour réaliser une source de lumière D1 selon la présente invention. La figure 6a représente plusieurs segments 26 en parallèle, chaque segment étant constitué de plusieurs groupes 27 en série. La figure 6b représente plusieurs segments 28 en série, chaque segment étant constitué de groupes 27 en parallèle.

Selon une variante de l'invention, la source de lumière électroluminescente comprend un ensemble de segments électroluminescents capables d'émettre à des longueurs d'onde $\lambda_{kc}$ différentes, la combinaison desdits segments générant un paramètre de luminance global résultant de la somme des paramètres de luminance de chacun des segments électroluminescents émettant à une desdites longueurs d'onde $\lambda_{kc}$.

Cette variante de l'invention peut s'avérer notamment intéressante lorsque l'on cherche à réaliser des sources de lumière électroluminescentes en lumière blanche et que l'on cherche à contrôler la répartition surfacique de la puissance émise, afin de contrôler la couleur perçue.

L'intérêt de la source de lumière de l'invention réside dans la segmentation des surfaces actives qui constitue également un moyen pour réduire les dispersions de performances des puces LEDs ou pour les modifier à la demande, les performances ajustables pouvant être :

- la tension de seuil globale de la LED ;
- la luminance globale de la LED ;
- l'uniformité spatiale de la luminance ;
- le courant de polarisation pour une luminance donnée.

Exemple de calibration de la luminance :

En sortie de production, les LEDs peuvent avoir une dispersion importante sur leurs paramètres comme par exemple la luminance. Cela signifie que pour un même courant de polarisation, la luminance obtenue varie entre 0 et $L_{max}$. Or la spécification de la LED impose de ne pouvoir vendre que les LEDs dont la luminance L est telle que : et avec

$$L_{spec\_min} < L < L_{spec\_max}$$

$$L_{spec\_min} = L_{spec\_nom} - \Delta L$$

$$L_{spec\_max} = L_{spec\_nom} + \Delta L.$$

et

$L_{spec\_nom}$, $L_{spec\_min}$ et $L_{spec\_max}$ étant respectivement des valeurs de luminance nominale cible, de luminance minimale cible et de luminance maximale cible.

La figure 7 représente la distribution statistique en production de la luminance d'une source de lumière de surface active S.

On peut donc voir que seule la partie de la population située entre $L_{spec\_min}$ et $L_{spec\_max}$ est à conserver. Toutes les autres pièces doivent être rejetées.

Dans le cas d'une source de lumière de surface S segmentée ayant tous ses segments allumés, la distribution spectrale est identique puisque la surface globale est la même. Toutes les LEDs ayant une luminance globale inférieure à $L_{spec\_min}$ sont rejetées puisque la luminance mesurée est la luminance maximale (tous les segments sont allumés).

Toutes les LEDs ayant une luminance supérieure à $L_{spec\_max}$ doivent également être rejetées. L'invention propose une solution permettant de ramener tous ces composants dans l'intervalle [$L_{spec\_min}$ ; $L_{spec\_max}$] par extinction d'un certain nombre de segments. La précision nécessaire d'ajustement du composant est $2*\Delta L = L_{spec\_max} - L_{spec\_min}$. Soit N le nombre de segments constituant la LED. Si $N \geq L_{max} / (2*\Delta L)$, alors il est possible de recentrer toutes les luminances supérieures à $L_{spec\_max}$ dans l'intervalle voulu en éteignant le nombre nécessaire de segments. Les surfaces T et T' correspondant aux distributions statistiques en production d'une source de lumière avant et après adressage sélectif et indiquées en figure 7 peuvent ainsi être rendues identiques .

Différents scénarii sont alors possibles dans le dimensionnement des segments. Ceux-ci peuvent être, selon une variante ne faisant pas partie de l'invention, de taille identique permettant un ajustement assez homogène de la luminosité, on a alors $N \geq L_{max}/(2*\Delta L)$.

A l'inverse si l'on veut minimiser le nombre de segments il est possible, comme c'est le cas dans une source de lumière selon l'invention, d'utiliser un dimensionnement binaire des segments.

Soit n l'entier tel que $2^{n-1} < (L_{max}-L_{spec})/\Delta L < 2^n$, alors il est possible de diviser la LED en n+2 groupes : un groupe principal ayant une luminosité théorique de $L_{spec\_nom}$ et n+1 groupes de tailles 1, 2, 4,...., $2^n$.

Ainsi, lorsque seul le groupe principal est alimenté, la luminance théorique obtenue est $L_{spec\_nom}$, les n+1 groupes permettant d'avoir une luminance comprise entre $L_{spec\_nom}$ à $L_{max}$.

Grâce à la présente invention, tous les composants ayant une luminance supérieure à la limite acceptable peuvent ainsi être recentrés autour de la valeur nominale en déconnectant le nombre adéquat de segments.

Pendant les phases de tests en production, différentes méthodes sont possibles pour calibrer la LED :

- une méthode de mesure individuelle systématique de tous les segments permettant ensuite de calculer la combinaison nécessaire pour obtenir la luminance nominale ;
- une méthode d'approximation successive jusqu'à l'obtention de la valeur finale.

Ces méthodes de tests permettent de définir quels segments doivent être allumés et quels autres doivent rester éteints une fois la LED mise en boitier. Il convient donc de passer par une phase de programmation avant, pendant ou après l'assemblage final.

Répartition spectrale des LEDs

L'ajustement de la luminance réelle de la LED autour de sa valeur nominale souhaitée, par extinction d'un certain nombre de segments peut entraîner une dégradation de l'uniformité spectrale de la LED. Cette dégradation peut être problématique si elle devient visible à l'œil nu ou si l'application dans laquelle le composant est utilisé nécessite une grande uniformité spectrale (phare de voiture par exemple).

Pour limiter ce phénomène, il est avantageusement possible de diviser les N segments décrits en P sous-segments ou groupes tels que décrit précédemment de manière à ce que le nombre total d'unités lumineuses Q soit Q=P*N. Ainsi chaque segment est constitué d'un multiple de sous-segments ou groupes.

En répartissant de manière uniforme ces groupes constituant un segment sur toute la surface active de la LED globale de surface S on peut améliorer l'uniformité lumineuse de la LED. Lorsqu'un segment est éteint, la luminance globale est diminuée de manière plus homogène.

Un cas particulièrement intéressant dans ce sens est celui des LEDs constituées de fils car il faut en général plusieurs milliers à plusieurs centaines de milliers de fils par puce. Ce sont autant de mini-segments mis en parallèle.

A l'inverse, une variante de l'invention consiste au contraire à utiliser la segmentation de la LED pour contrôler le spectre d'émission de la LED et contrôler les propriétés de l'indicatrice d'émission de chaque puce.

L'indicatrice d'émission dépend d'un certain nombre de paramètres parfaitement reproductibles : la géométrie de la puce, la forme du boitier, les connections électriques de la puce (wirebonding ou contact face arrière) etc... Ces paramètres peuvent modifier la forme d'onde de la lumière émise par des effets d'ombres par exemple.

Grâce à la présente invention il devient possible d'éteindre et d'allumer certains segments pour compenser ces paramètres. Il est ainsi par exemple possible d'augmenter la contribution du centre par rapport à certains bords ou l'inverse.

Un procédé d'ajustement de la répartition spatiale de la luminance d'une source de lumière électroluminescente est décrit, caractérisé en ce qu'il comprend les étapes suivantes :

- la détermination d'une répartition spatiale de référence d'un paramètre de luminance de ladite source de lumière ;
- la commande sélective de segments d'éléments discrets électroluminescents, de surfaces d'émission différentes, de manière à obtenir une répartition surfacique de paramètre de luminance égale à ladite répartition spatiale de référence .

Programmation des LEDs

Différentes méthodes sont décrites pour programmer les LEDs et stocker l'information « allumé » ou « éteint » pour chaque segment.

La source de lumière est un composant LED. Comme tout composant LED, la source de lumière possède au moins 2 bornes d'alimentation électrique, l'une représentant l'anode et l'autre la cathode. Ce composant LED est composé de segments lumineux. Ces segments peuvent également être divisés en groupes. Un des principes est de pouvoir sélectionner quels segments vont être alimentés électriquement.

Une des configurations proposées est que les segments sont électriquement connectés en parallèle. Ils peuvent donc avoir une de leurs bornes d'alimentation commune, par exemple l'anode. Cette connexion commune d'une de leurs bornes peut se faire face avant du substrat contenant les LEDs par une connexion métallique globale.

Les segments sont alors sélectionnables en connectant individuellement leur deuxième borne électrique.

Selon une variante de l'invention, la connexion de cette deuxième borne est réalisée de manière physique lors de la mise en boitier de la LED. Chaque segment possède, de manière préférentielle en bord de puce, une terminaison métallique appelée « plot ». Il suffit de connecter ou pas chaque plot par câblage filaire appelé couramment « wire bonding » au plot global correspondant à la deuxième borne du boitier du composant LED pour que le segment soit allumé ou non.

Selon une variante de l'invention, la connexion de cette deuxième borne peut se faire via un réseau de pistes métalliques. La source de lumière électroluminescente comprend alors un assemblage de composants LED et un circuit d'interconnexions électriques desdits composants LED.

Chaque piste est connectée à une des bornes d'alimentation de chaque segment d'un côté et débouche sur un plot métallique à son autre extrémité. Suivant le même principe que la variante précédente, les plots connectés aux segments devant être allumés peuvent être connectés ou non au plot global du boîtier par une liaison filaire de type câblage filaire « wire bonding ».

Selon une variante de l'invention ce réseau d'interconnexions peut également établir la connexion électrique entre les groupes d'un même segment.

Selon une autre variante de l'invention, les pistes conductrices comportent des mécanismes programmables permettant de détruire de manière sélective des connexions préétablies, pouvant être de type fusibles métalliques. Dans ce cas, la sélection des segments désirés n'est pas réalisée en connectant un groupe. Au contraire, tous les segments sont a priori connectés et les segments qui ne doivent pas être allumés sont déconnectés par destruction de ce mécanisme programmable.

Selon une variante de l'invention, ce mécanisme peut être détruit par application d'une source d'énergie électrique (par exemple une source de courant) à ses bornes lui injectant une énergie (par exemple un courant) suffisamment importante pour le détruire.

Selon une autre variante de l'invention, ce mécanisme peut être détruit par l'application d'une source d'énergie lumineuse (par exemple un laser) permettant un échauffement local suffisant pour le détruire.

Selon l'invention, la source de lumière de l'invention comprend au moins un circuit de commande comportant des moyens pour activer indépendamment un nombre variable de segments de surfaces d'émission différentes et permettre d'ajuster ledit paramètre de luminance de ladite source.

Selon une variante de l'invention, ledit circuit de commande comprend des moyens de commande binaire.

Selon une variante de l'invention, le circuit de commande est un circuit imprimé comportant des pistes conductrices reliées auxdits segments et un module électronique de commande, ledit module permettant d'activer au moins une partie desdits segments comprenant les éléments discrets électroluminescents, via les pistes conductrices.

Selon une variante de l'invention, le module électronique de commande comporte un répertoire de couples de données : pistes de commande/ paramètre global de luminance dudit dispositif.

Selon une variante de l'invention, le module électronique de commande peut être directement connecté à la puce LED par un assemblage de type « chip-to-chip » ne nécessitant pas de pistes conductrices.

De manière générale, la présente invention adresse le problème de la variabilité de paramètre de luminance d'une source de lumière électroluminescente comportant un ensemble d'éléments discrets électroluminescents, pouvant être des éléments planaires ou des éléments filaires, coniques, tronconiques ou pyramidaux.

Ainsi une telle source de lumière comprenant un ensemble d'éléments discrets, présente de manière générale, un paramètre de luminance totale égale à la somme des paramètres de luminance de chacun des éléments discrets électroluminescents.

Pour obtenir des sources de lumière électroluminescentes de très bonne reproductibilité, prenant en compte des variations de paramètres de luminance élémentaire, il est proposé dans la présente invention, une source de lumière électroluminescente selon la revendication 1, comprenant des segments comprenant au moins un élément discret électroluminescent présentant une surface d'émission, avec

- au moins une partie desdits segments présentant des surfaces d'émission différentes entre lesdits segments et/ou un nombre d'éléments discrets électroluminescents différents entre lesdits segments ;
- et au moins un circuit de commande comportant des moyens pour adresser un nombre variable de segments, permettant d'ajuster ledit paramètre de luminance dudit dispositif électroluminescent ou un circuit de commande dans lequel des circuits de connexions ont été préalablement définies.

Ainsi des segments électroluminescents de taille variable, variant en puissance de 2, de manière à réduire le nombre de commande, associés à des moyens de commande indépendants de certains segments permettent d'ajuster un paramètre de luminance globale avec une commande optimisée, et permettent ainsi de disposer d'une source de lumière électroluminescente ajustable pouvant répondre à des cahiers des charges prédéfinis.

Le circuit de commande peut par exemple de manière classique comprendre un circuit imprimé comportant un ensemble de pistes conductrices et des interfaces permettant de fournir l'énergie nécessaire pour activer les segments comprenant les éléments discrets électroluminescents. Le circuit de commande peut aussi comprendre également un module électronique de commande pouvant être réalisé à base de microprocesseurs et de circuits numériques.

Selon la présente invention, le circuit de commande peut avantageusement comprendre des moyens de commande binaire, ne nécessitant pas de variations de puissance pour alimenter l'ensemble des éléments unitaires électroluminescents. En effet, selon la présente invention, Il devient possible de couvrir en continu avec une commande binaire, et un minimum de lignes de commande, une large gamme de réglage en L(I), ou L(V) ou Lmax, ....

En phase de test de paramètres de luminance obtenue, réalisé par exemple sous pointe, on peut scanner et fournir auprès d'un utilisateur, des combinaisons optimales de routage pour un jeu de critères donnés. L'utilisateur peut ainsi disposer de ces combinaisons pour reproduire les combinaisons d'intérêt, notamment de telles combinaisons peuvent être utilisées lors de câblage de puce dans des boîtiers.

Exemple de procédé d'ajustement d'une source de lumière électroluminescente émettant une lumière blanche.

Il existe actuellement plusieurs technologies permettant d'obtenir des LEDs émettant une lumière blanche. Un procédé de mise en œuvre direct consiste à combiner trois LEDs émettant respectivement dans le rouge, le vert et le bleu. Néanmoins, le pilotage des différentes sources peut s'avérer délicat, dans la mesure où l'on doit mélanger des radiations rouges, vertes et bleues avec des proportions bien précises pour obtenir le « meilleur » blanc possible.

De manière générale, la couleur d'une source lumineuse est comparée à celle d'un corps noir théorique chauffé entre 2 000 et 10 000 K, qui aurait dans le domaine de la lumière visible un spectre d'émission similaire à la couleur considérée. La couleur apparente d'une source lumineuse varie du rouge orangé de la flamme d'une bougie (1 850 K) à bleuté dans le cas d'un flash électronique (entre 5 000 et 6 500 K selon les fabricants).

Pour apprécier l'aspect et la qualité de la lumière, il convient d'associer à la température de couleur l'indice de rendu de couleur ou IRC, chiffre entre 0 et 100 % qualifiant le respect des couleurs.

Dans le cas d'une LED blanche, on parle d'une température de couleur allant de blanc chaud à blanc froid qui se mesure en degré Kelvin (°K). Le blanc chaud est donc une couleur de blanc se rapprochant d'une couleur halogène ou incandescente et se situe sur une valeur comprise entre 2500°K (très jaune) et 3500°K (moins jaune) tandis qu'un blanc froid oscille entre 6000°K (blanc légèrement froid) et 7.000°K (blanc très froid). Le blanc couvre donc une très vaste plage de températures de couleurs. En général l'œil humain commence à percevoir un blanc comme Froid à partir de 6000°K (entre 6000°K et 7.000°K). Plus le nombre de degrés Kelvin (°K) est élevé et plus la couleur est Froide et Bleue. Le blanc Day-Light (lumière du jour) se situe sur une valeur comprise entre 5000°K et 6000°K, c'est le blanc le plus neutre qui soit et certainement l'un des plus appréciés car permettant de très bien distinguer les couleurs réelles des objets présents dans l'atmosphère ambiante.

Afin d'obtenir une source de lumière électroluminescente émettant dans le blanc et ce de manière reproductible, il est nécessaire de contrôler au mieux les différentes pondérations des différentes couleurs.

Selon la présente invention, il devient possible d'assurer une bonne reproductibilité à partir de la détermination d'une luminance moyenne résultante et de la pondération de différents segments émettant dans le rouge, le vert, le bleu, après phase de test et reproduction des combinaisons de connexion conduisant à une luminance résultante moyenne prédéfinie.

On peut aussi bien envisager de fonctionner avec trois alimentations, une par couleur, ou bien encore avec une seule alimentation. La longueur d'émission peut être ajustée en utilisant des alliages par exemple à base de InGaN et comprenant des compositions différentes permettant d'ajuster la longueur d'onde d'émission recherchée.

Les combinaisons de segments d'éléments discrets électroluminescents, d'émission de couleurs différentes, peuvent être réalisées en organisant ou en répartissant de manière aléatoire lesdits segments sur l'ensemble d'un substrat ou sur l'ensemble d'un support.

Chaque segment peut être interconnecté de manière différente afin d'ajuster la colorimétrie de manière active (possibilité de régler la couleur par commande) ou passive (la combinaison a été figée préalablement).

En effet, de manière générale, la source de lumière électroluminescente de l'invention, peut être finalisée selon différents procédés.

A partir d'un ensemble de segments d'éléments discrets électroluminescents, on peut rechercher au test sous pointe la combinaison de segments conduisant à la caractéristique souhaitée en termes de paramètre de luminance cible. On définit alors la combinaison de connexions permettant d'obtenir ladite luminance cible liée au cahier des charges généralement requis. Cette combinaison de connexions peut alors être utilisée lors du câblage ultérieur de la puce dans un boîtier.

On peut disposer d'un seul plot de connexion, si l'ensemble des connexions a été préalablement établi, on peut alors détruire le lien avec les groupes non utilisés avec un système de fusible. On peut également créer le le lien avec les groupes utilisés avec un système de dépôt de matière (jet d'encre, ....).

Selon la présente invention, il est également possible qu'un client réalise la source de lumière électroluminescente après livraison de composants LED et procède à l'assemblage, en utilisant les interconnexions électriques adéquates entre composants, qui lui sont également indiquées.

**Revendications**

1. Source de lumière électroluminescente à paramètre de luminance ajusté ou ajustable ((I, L), (V,L), ...) dans laquelle :

    - ladite source comporte un ensemble de N segments ($S_i$) avec N > 2, chaque segment présentant une surface d'émission et comprenant un élément discret électroluminescent ou plusieurs éléments discrets électroluminescents connectés de manière permanente entre eux, avec :

        ∘ soit ladite source comprenant des éléments filaires ($NT_i$), coniques, tronconiques ou pyramidaux à la surface d'un substrat (11) et répartis en sous-ensembles correspondant auxdits segments, chaque segment possédant un nombre différent d'éléments filaires, coniques, tronconiques ou pyramidaux connectés de manière permanente entre eux, les éléments discrets électroluminescents étant lesdits éléments filaires, coniques, tronconiques ou pyramidaux ;
        ∘ soit ladite source comprenant une diode électroluminescente (LED) présentant une partie active émissive (203) segmentée de manière à définir lesdits segments ($S_i$), ladite diode électroluminescente (LED) présentant une structure planaire d'empilement de couches (203, 202) à la surface d'un substrat (201), les segments ayant une surface différente, chaque segment étant un élément discret électroluminescent;
        ∘ soit ladite source comprenant un assemblage de puces de diodes électroluminescentes (LEDs) discrètes, réparties entre lesdits segments, chaque segment étant constitué d'au moins une puce, les segments comprenant un nombre différent de puces de diodes électroluminescentes (LEDs) connectées de manière permanente entre elles ou des puces de diodes électroluminescentes (LEDs) de tailles différentes, les éléments discrets électroluminescents étant lesdites puces de diodes électroluminescentes (LEDs) discrètes ;

    - ladite source comprenant des moyens de commande (300) d'au moins une partie desdits segments ($S_i$);
    **caractérisée en ce que**

- lesdits segments présentent des surfaces d'émission variant en puissance de 2.

2. Source de lumière électroluminescente selon la revendication 1, **caractérisée en ce qu'**au moins une partie desdits segments est constituée de sous-ensembles d'éléments discrets 3D appelés groupes et positionnés de manière non-contigue, lesdits groupes étant connectés de manière permanente entre eux.

3. Source de lumière électroluminescente selon la revendication 2, **caractérisée en ce que** lesdits groupes constituant les segments sont disposés de manière aléatoire.

4. Source de lumière électroluminescente selon l'une des revendications 1 à 3, **caractérisée en ce que** les éléments filaires, coniques, tronconiques ou pyramidaux sont connectés électriquement par une électrode supérieure commune.

5. Source de lumière électroluminescente selon l'une des revendications 1 à 3, **caractérisée en ce que** les segments sont connectés par plusieurs niveaux de métal sur la face processée des puces assemblées en mode retourné « flip-chip ».

6. Source de lumière électroluminescente selon l'une des revendications 1 à 3, **caractérisée en ce que** les différentes diodes électroluminescentes (LEDs) constituant les segments sont reportées sur un support assurant également la connexion électrique des segments et groupes.

7. Source de lumière électroluminescente selon l'une des revendications 2 à 4, **caractérisée en ce que** chaque groupe d'éléments filaires, coniques, tronconiques ou pyramidaux d'un même segment est relié à au moins un via traversant le substrat et permettant la connexion des groupes dudit segment en face arrière.

8. Source de lumière électroluminescente selon l'une des revendications 1 à 7, **caractérisée en ce que** les moyens de commande comprennent un circuit de commande comportant des moyens pour activer indépendamment un nombre variable de segments et permettant d'ajuster ledit paramètre de luminance de ladite source.

9. Source de lumière électroluminescente selon la revendication 8, **caractérisée en ce que** le circuit de commande est un circuit imprimé comportant des pistes conductrices reliées aux segments et un module électronique de commande, ledit module permettant d'activer au moins une partie desdits segments via les pistes conductrices.

10. Source de lumière électroluminescente selon l'une des revendications 8 ou 9, **caractérisée** ce que ledit circuit de commande comprend des moyens de commande binaire.

11. Source de lumière électroluminescente selon la revendication 10, **caractérisée en ce que** le module électronique de commande comporte un répertoire de couples de données : routage des pistes de commande/ paramètre global de luminance dudit dispositif.

12. Source de lumière électroluminescente selon la revendication 9, **caractérisée en ce que** les pistes conductrices comportent des moyens de programmation sélective et permanente des connexions préétablies, lesdits moyens pouvant être de type fusibles métalliques.

13. Source de lumière électroluminescente selon la revendication 8, **caractérisée en ce que** les moyens de commande comprennent un circuit de commande comportant des pistes conductrices reliant chaque segment à un ou plusieurs plots métalliques permettant leur connexion filaire (appelée Wire bonding) lors de la mise en boitier de la dite source.

14. Procédé de fabrication d'une source de lumière électroluminescente selon l'une des revendications 1 à 13.

15. Procédé de fabrication selon la revendication 14, d'une source de lumière électroluminescente selon la revendication 12 comprenant des moyens de programmation sélective et permanente des connexions préétablies de type fusibles métalliques, **caractérisé en ce qu'**il comprend une étape de réalisation des moyens de commande d'au moins une partie desdits segments ($S_i$) comportant une étape d'élimination des fusibles métalliques qui est réalisée par ablation laser.

16. Source de lumière électroluminescente selon l'une des revendications 1 à 13, **caractérisée en ce que** les segments sont capables d'émettre à des longueurs d'onde $\lambda_{pk}$ différentes, la combinaison desdits segments générant un paramètre de luminance global résultant de la somme des paramètres de luminance de chacun des segments émettant à une desdites longueur d'onde $\lambda_{pk}$.

17. Utilisation d'une source électroluminescente selon l'une des revendications 1 à 13 pour en ajuster un paramètre de luminance, **caractérisé en ce qu'**elle comprend les étapes suivantes :

- la détermination d'une valeur de paramètre de luminance de référence ($L_{ref}$) de ladite source de lumière électroluminescente ;
- la commande sélective de segments de surface d'émission différente d'éléments discrets électroluminescents de manière à obtenir ledit paramètre de luminance de référence ($Lr_{ef}$).

18. Utilisation d'une source électroluminescente selon l'une des revendications 1 à 13 pour en ajuster la répartition spatiale d'un paramètre de luminance, caractérisé ce qu'elle comprend les étapes suivantes :

- la détermination d'une répartition spatiale de référence d'un paramètre luminance ($L_{ref(x,y)}$) de ladite source de lumière électroluminescente ;
- la commande sélective de segments de surfaces d'émission différentes d'éléments discrets de manière à obtenir une répartition surfacique de paramètre de luminance L(x,y) égale à ladite répartition spatiale de référence ($L_{ref(x,y)}$).

19. Procédé de fabrication selon la revendication 14 d'une source électroluminescente selon la revendication 11, **caractérisé en ce qu'**il comprend :

- une phase de test comportant les étapes suivantes :

∘ la détermination d'un répertoire de couples de données : configuration de routage de pistes conductrices/ mesure de paramètre global de luminance de ladite source de lumière électroluminescente ;
∘ la sélection dans ledit répertoire de configurations de routage de pistes conductrices permettant d'obtenir des paramètres de luminance conformes à des spécifications prédéfinies de paramètre de luminance ;

- la détermination d'une configuration optimale de routage répondant aux spécifications prédéfinies.

20. Procédé de fabrication selon la revendication 14 d'une source de lumière électroluminescente selon l'une des revendications 1 à 13, **caractérisé en ce qu'**il comprend la réalisation des moyens de commande d'au moins une partie desdits segments ($S_i$) comportant :

- une étape de détermination de spécifications de référence de ladite source de lumière électroluminescente ;
- la réalisation d'un circuit de commande comportant un réseau de pistes conductrices destinées à l'activation de l'ensemble des segments d'éléments discrets électroluminescents de ladite source de lumière électroluminescente ;

- l'élimination d'un sous-ensemble de connexions de manière à pouvoir activer une sélection de segments d'éléments discrets électroluminescents pour obtenir lesdites spécifications de référence.

**Patentansprüche**

1. Elektrolumineszenz-Lichtquelle mit einem verstellten oder verstellbaren Leuchtdichteparameter ((I, L), (V,L), ...), wobei:

- die Quelle mindestens einen Satz von N Segmenten ($S_i$) umfasst, wobei N > 2 ist, wobei jedes Segment eine Emissionsfläche aufweist und ein diskretes Elektrolumineszenz-Element oder mehrere permanent miteinander verbundene diskrete Elektrolumineszenz-Elemente umfasst, wobei:

∘ entweder die Quelle fadenförmige ($NT_i$), konische, kegelstumpfförmige oder pyramidenförmige Elemente auf der Oberfläche eines Substrats (11) umfasst, die in Teilsätze entsprechend den Segmenten unterteilt sind, wobei jedes Segment eine andere Anzahl von permanent untereinander verbundenen fadenförmigen, konischen, kegelstumpfförmigen oder pyramidenförmigen Elementen besitzt, wobei die diskreten Lumineszenz-Elemente die fadenförmigen, konischen, kegelstumpfförmigen oder pyramidenförmigen Elemente sind;
∘ oder die Quelle eine Elektrolumineszenz-Diode (LED) mit einem aktiven Emissionsteil (203) aufweist, der so segmentiert ist, dass er die Segmente ($S_i$) definiert, wobei die Elektrolumineszenz-Diode (LED) eine planare Schichtstapelstruktur (203, 202) auf der Oberfläche eines Substrats (201) aufweist, wobei die Segmente eine andere Oberfläche haben, wobei jedes Segment ein diskretes Elektrolumineszenz-Element ist;
∘ oder die Quelle eine Baugruppe von zwischen den Segmenten verteilten diskreten Elektrolumineszenz-Diodenchips (LEDs) umfasst, wobei jedes Segment aus mindestens einem Chip gebildet ist, wobei die Segmente eine unterschiedliche Anzahl von permanent miteinander verbundenen Elektrolumineszenz-Diodenchips (LEDs) oder Elektrolumineszenz-Diodenchips (LEDs) unterschiedlicher Größen umfassen, wobei die diskreten Elektrolumineszenz-Elemente die diskreten Elektrolumineszenz-Diodenchips (LEDs) sind;

- wobei die Quelle Mittel (300) zum Steuern mindestens eines Teils der Segmente ($S_i$) umfasst;
**dadurch gekennzeichnet, dass**
- die Segmente Emissionsflächen mit einer Leistung von 2 aufweisen.

2. Elektrolumineszenz-Lichtquelle nach Anspruch 1, **dadurch gekennzeichnet, dass** mindestens ein Teil der Segmente von diskreten 3D-Elementeunterbaugruppen gebildet wird, Gruppen genannt, und auf nicht zusammenhängende Weise positioniert, wobei die Gruppen permanent untereinander verbunden sind.

3. Elektrolumineszenz-Lichtquelle nach Anspruch 2, **dadurch gekennzeichnet, dass** die die Segmente bildenden Gruppen auf zufällige Weise angeordnet sind.

4. Elektrolumineszenz-Lichtquelle nach einem der Ansprüche 1 bis 3, **dadurch gekennzeichnet, dass** die fadenförmigen, konischen, kegelstumpfförmigen oder pyramidenförmigen Elemente elektrisch durch eine gemeinsame obere Elektrode verbunden sind.

5. Elektrolumineszenz-Lichtquelle nach einem der Ansprüche 1 bis 3, **dadurch gekennzeichnet, dass** die Segmente durch mehrere Metallebenen auf der Prozessseite der im Flipchip-Modus zusammengesetzten Chips verbunden sind.

6. Elektrolumineszenz-Lichtquelle nach einem der Ansprüche 1 bis 3, **dadurch gekennzeichnet, dass** die die Segmente bildenden unterschiedlichen Elektrolumineszenz-Dioden (LED) auf einen Träger übertragen werden, der auch die elektrische Verbindung der Segmente und Gruppen gewährleistet.

7. Elektrolumineszenz-Lichtquelle nach einem der Ansprüche 2 bis 4, **dadurch gekennzeichnet, dass** jede Gruppe von fadenförmigen, konischen, kegelstumpfförmigen oder pyramidenförmigen Elementen eines selben Segments mit mindestens einer Durchkontaktierung verbunden ist, die das Substrat durchquert und die Verbindung der Gruppen des Segments auf der Rückseite zulässt.

8. Elektrolumineszenz-Lichtquelle nach einem der Ansprüche 1 bis 7, **dadurch gekennzeichnet, dass** die Steuermittel eine Steuerschaltung umfassen, die Mittel zum unabhängigen Aktivieren einer variablen Anzahl von Segmenten umfasst und das Justieren des Leuchtdichteparameters der Quelle zulässt.

9. Elektrolumineszenz-Lichtquelle nach Anspruch 8, **dadurch gekennzeichnet, dass** die Steuerschaltung eine gedruckte Schaltung ist, die Leiterbahnen umfasst, die mit den Segmenten und einem elektronischen Steuermodul verbunden sind, wobei das Modul die Aktivierung mindestens eines Teils der Segmente über die Leiterbahnen zulässt.

10. Elektrolumineszenz-Lichtquelle nach einem der Ansprüche 8 oder 9, **dadurch gekennzeichnet, dass** die Steuerschaltung binäre Steuermittel umfasst.

11. Elektrolumineszenz-Lichtquelle nach Anspruch 10, **dadurch gekennzeichnet, dass** das elektronische Steuermodul ein Repertoire von Datenpaaren umfasst: Routing von Steuerbahnen/globaler Leuchtdichteparameter der Vorrichtung.

12. Elektrolumineszenz-Lichtquelle nach Anspruch 9, **dadurch gekennzeichnet, dass** die Leiterbahnen Mittel zum selektiven und permanenten Programmieren der voreingestellten Verbindungen umfassen, wobei die Mittel vom Metallsicherungstyp sein können.

13. Elektrolumineszenz-Lichtquelle nach Anspruch 8, **dadurch gekennzeichnet, dass** die Steuermittel eine Steuerschaltung umfassen, die Leiterbahnen umfasst, die jedes Segment mit einem oder mehreren Metallpads verbinden, die ihre fadenförmige Verbindung (Wire-Bonding genannt) beim Verkapseln der Quelle zulassen.

14. Verfahren zur Herstellung einer Elektrolumineszenz-Lichtquelle nach einem der Ansprüche 1 bis 13.

15. Verfahren zur Herstellung nach Anspruch 14 einer Elektrolumineszenz-Lichtquelle nach Anspruch 12, die Mittel zum selektiven und permanenten Programmieren der voreingestellten Verbindungen des Metallsicherungstyps umfasst, **dadurch gekennzeichnet, dass** es einen Schritt des Realisierens der Steuermittel mindestens eines Teils der Segmente ($S_i$) beinhaltet, das einen Schritt des Eliminierens der Metallsicherungen beinhaltet, der durch Laserablation realisiert wird.

16. Elektrolumineszenz-Lichtquelle nach einem der Ansprüche 1 bis 13, **dadurch gekennzeichnet, dass** die Segmente mit unterschiedlichen Wellenlängen $\lambda_{pk}$ emittieren können, wobei die Kombination der Segmente einen globalen Leuchtdichteparameter erzeugt, der aus der Summe der Leuchtdichteparameter von jedem der mit einer der Wellenlängen $\lambda_{pk}$ emittierenden Segmente resultiert.

17. Verwendung einer Elektrolumineszenzquelle nach einem der Ansprüche 1 bis 13, um damit einen Leuchtdichteparameter einzustellen, **dadurch gekennzeichnet, dass** sie die folgenden Schritte beinhaltet:

- Bestimmen eines Referenz-Leuchtdichteparameterwertes (L$_{ref}$) der Elektrolumineszenz-Lichtquelle;
- selektives Steuern verschiedener Emissionsflächensegmente von diskreten Elektrolumineszenz-Elementen, um den Referenz-Leuchtdichteparameter (L$_{ref}$) zu erhalten.

18. Verwendung einer Elektrolumineszenzquelle nach einem der Ansprüche 1 bis 13, um damit die räumliche Verteilung eines Leuchtdichteparameters einzustellen, **dadurch gekennzeichnet, dass** er die folgenden Schritte beinhaltet:

    - Bestimmen einer räumlichen Referenzverteilung eines Leuchtdichteparameters (L$_{ref(x,y)}$) der Elektrolumineszenz-Lichtquelle;
    - selektives Steuern verschiedener Emissionsoberflächensegmente von diskreten Elementen, um eine Leuchtdichteparameter-Oberflächenverteilung L(x,y) gleich der räumlichen Referenzverteilung (L$_{ref(x,y)}$) zu erhalten.

19. Verfahren zur Herstellung nach Anspruch 14 einer Elektrolumineszenzquelle nach Anspruch 11, **dadurch gekennzeichnet, dass** es Folgendes beinhaltet:

    - eine Prüfphase mit den folgenden Schritten:

      ∘ Bestimmen eines Repertoires von Datenpaaren: Konfigurieren des Routings von Leiterbahnen / Messen des globalen Leuchtdichteparameters der Elektrolumineszenz-Lichtquelle;
      ∘ Auswählen, in dem Repertoire, von Konfigurationen von Leiterbahn-Routing, die es zulassen, Leuchtdichteparameter entsprechend vordefinierten Leuchtdichteparameterspezifikationen zu erhalten;

    - Bestimmen einer optimalen Routing-Konfiguration, die den vordefinierten Spezifikationen entspricht.

20. Verfahren zur Herstellung nach Anspruch 14 einer Elektrolumineszenz-Lichtquelle nach einem der Ansprüche 1 bis 13, **dadurch gekennzeichnet, dass** sie die Realisierung der Steuermittel mindestens eines Teils der Segmente (S$_i$) umfasst, das Folgendes beinhaltet:

    - einen Schritt des Bestimmens von Referenzspezifikationen der Elektrolumineszenz-Lichtquelle;
    - Realisieren einer Steuerschaltung, die ein Netzwerk von Leiterbahnen umfasst, bestimmt zum Aktivieren des Satzes von diskreten Elektrolumineszenz-Elementesegmenten der Elektrolumineszenz-Lichtquelle;
- Eliminieren eines Teilsatzes von Verbindungen, um eine Auswahl von diskreten Elektrolumineszenz-Elementesegmenten aktivieren zu können, um die Referenzspezifikationen zu erhalten.

**Claims**

1. An electroluminescent light source with an adjusted or adjustable luminance parameter ((I, L), (V, L), ...), wherein:

    - said source includes a set of N segments (S$_i$), where N>2, each segment having an emission area and comprising a discrete electroluminescent element or multiple discrete electroluminescent elements connected permanently to one another with:

      ∘ either said source comprising filamentous (NT$_i$), conical, frustoconical or pyramidal elements on the surface of a substrate (11) and distributed in subsets corresponding to said segments, each segment possessing a different number of filamentous, conical, frustoconical or pyramidal elements connected permanently to one another, said discrete electroluminescent elements being said filamentous, conical, frustoconical or pyramidal elements;
      ∘ either said source comprising a light-emitting diode (LED) having an emissive active portion (203) that is segmented so as to define said segments (S$_i$), said light-emitting diode (LED) having a planar structure of stacked layers (203, 202) on the surface of a substrate (201), the segments having different areas, each segment being a discrete electroluminescent element;
      ∘ either said source comprising an assembly of discrete light-emitting diode (LED) chips, distributed between said segments, each segment consisting of at least one chip, the segments comprising a different number of light-emitting diode (LEDs) chips connected permanently to one another or light-emitting diode (LEDs) chips of different sizes, said discrete electroluminescent elements being said discrete light-emitting diode (LED) chips;

    - said source comprising means for controlling (300) at least a portion of said segments (S$_i$); **characterized in that**
    - said segments have emission areas varying by power of 2.

2. The electroluminescent light source according to claim 1, **characterized in that** at least a portion of said segments consists of subsets of discrete 3D elements, referred to as groups and positioned non-contiguously, said groups being connected permanently to one another.

3. The electroluminescent light source according to claim 2, **characterized in that** said groups constituting the segments are positioned randomly.

4. The electroluminescent light source according to one of claims 1 to 3, **characterized in that** the filamentous, conical, frustoconical or pyramidal elements are connected electrically by means of a common upper electrode.

5. The electroluminescent light source according to one of claims 1 to 3, **characterized in that** the segments are connected by multiple metal levels on the processed face of the chips assembled according to the flip-chip method.

6. The electroluminescent light source according to one of claims 1 to 3, **characterized in that** the various light-emitting diodes (LEDs) constituting the segments are transferred onto a carrier that also electrically connects the segments and groups.

7. The electroluminescent light source according to one of claims 2 to 4, **characterized in that** each group of filamentous, conical, frustoconical or pyramidal elements of one and the same segment is connected to at least one via passing through the substrate and allowing the groups of said segment to be connected on the back face.

8. The electroluminescent light source according to one of claims 1 to 7, **characterized in that** the control means comprise a control circuit including means for independently activating a variable number of segments and allowing said luminance parameter of said source to be adjusted.

9. The electroluminescent light source according to claim 8, **characterized in that** the control circuit is a printed circuit board including conductive tracks that are linked to the segments and an electronic control module, said module allowing at least a portion of said segments to be activated via the conductive tracks.

10. The electroluminescent light source to one of claims 8 or 9, **characterized in that** said control circuit comprises binary control means.

11. The electroluminescent light source according to claim 10, **characterized in that** the electronic control module includes a directory of data pairs: layout of the control tracks/overall luminance parameter of said device.

12. The electroluminescent light source according to claim 9, **characterized in that** the conductive tracks include means for selectively and permanently programming the pre-established connections, said means potentially being metal fusible elements.

13. The electroluminescent light source according to claim 8, **characterized in that** the control means comprise a control circuit including conductive tracks connecting each segment to one or more metal pads enabling the wire bonding thereof when packaging said source.

14. A method for manufacturing an electroluminescent light source according to one of claims 1 to 13.

15. The method for manufacturing according to claim 14, an electroluminescent light source according to claim 12, comprising means for selectively and permanently programming the pre-established connections, being metal fusible, **characterized in that** it comprises a step of producing the means for controlling at least a portion auf said segments ($S_i$), comprising a step of removing the metal fusible elements by laser ablation.

16. The electroluminescent light source according to one of claims 1 to 13, **characterized in that** the segments are capable of emitting in different wavelengths $\lambda_{pk}$, the combination of said segments producing an overall luminance parameter resulting from the sum of the luminance parameters of each of the segments emitting in one of said wavelengths $\lambda_{pk}$.

17. The use of an electroluminescent light source according to one of claims 1 to 13 for adjusting a luminance parameter, **characterized in that** it comprises the following steps:

    - determining a reference luminance parameter value ($L_{ref}$) of said electroluminescent light source;
    - selectively controlling segments of different emission areas of discrete electroluminescent elements so as to obtain said reference luminance parameter ($L_{ref}$).

18. The use of an electroluminescent light source according to one of claims 1 to 13 for adjusting the spatial distribution of a luminance parameter, **characterized in that** it comprises the following steps:

- determining a reference spatial distribution of a luminance parameter ($L_{ref(x,y)}$) of said electroluminescent light source;

- selectively controlling segments of different emission areas of discrete elements so as to obtain a luminance parameter surface distribution L(x,y) that is equal to said reference spatial distribution ($L_{ref(x,y)}$).

19. The method for manufacturing according to claim 14, an electroluminescent light source according to claim 11, **characterized in that** it comprises:

    - a test phase including the following steps:

        o determining a directory of data pairs: configuration of layout of conductive tracks/measurement of overall luminance parameter of said electroluminescent light source;

        o selecting, in said directory, conductive track layout configurations allowing luminance parameters that are in accordance with predefined luminance parameter specifications to be obtained;

    - determining an optimum layout configuration that meets the predefined specifications.

20. The method for manufacturing according to claim 14, an electroluminescent light source according to one of claims 1 to 13, **characterized in that** it comprises producing the means for controlling at least a portion auf said segments ($S_i$), comprising:

    - a step of determining reference specifications of said electroluminescent light source;

    - producing a control circuit including a network of conductive tracks that are intended to activate the set of segments of discrete electroluminescent elements of said electroluminescent light source;

    - removing a subset of connections so as to be able to activate a selection of segments of discrete electroluminescent elements in order to obtain said reference specifications.

NT$_i$

50

31

30

60

40

20

21

11

10

# FIG.1

200

S$_1$  S$_2$  S$_3$  S$_4$

100

300

# FIG.2

Segmentation

| S₁ | S₂ | S₃ | S₄ |
| | | | S₅ |

Puce LED 2D

# FIG.3a

$S_1$   $S_2$   $S_3$   $S_4$

101   102   202   203   300

201

# FIG.3b

FIG.3c

FIG.3d

**FIG.4**

**FIG.5a**

**FIG.5b**

FIG.6a

FIG.6b

FIG.7

**EP 3 238 240 B1**

## RÉFÉRENCES CITÉES DANS LA DESCRIPTION

**Documents brevets cités dans la description**

- EP 2778511 A
- DE 102012102301
- WO 2010014032 A